# EUROPÄISCHE PATENTSCHRIFT

(11) **EP 1 033 813 B1**
(45) Veröffentlichungstag und Bekanntmachung des Hinweises auf die Patenterteilung: **26.04.2006**
(21) Anmeldenummer: 00103813.2
(22) Anmeldetag: 23.02.2000
(51) Int. Cl.: H04B 1/10, H03J 1/00

(54) **Rundfunkempfangsvorrichtung und Verfahren zum Steuern einer Rundfunkempfangsvorrichtung**
Radio receiver system and method for controlling a radio receiver system
Système de réception radio et méthode pour contrôler un système de réception radio

(30) Priorität: 01.03.1999 DE 19908855
(43) Veröffentlichungstag der Anmeldung: 06.09.2000
(73) Patentinhaber: Delphi Technologies, Inc., Troy, MI 48007 (US)
(72) Erfinder: Szydlowski, Zbigniew, 31139 Hildesheim (DE); Shatara, Raed S., Kokomo, IN 46901 (US)
(74) Vertreter: Manitz, Finsterwald & Partner GbR

(56) Entgegenhaltungen:
- EP-A- 0 715 417
- US-A- 5 307 515
- US-A- 5 339 455
- US-A- 5 564 093

## Beschreibung

Die Erfindung betrifft ein Verfahren zum Steuern der Durchlaßbandbreite beim Filtern eines Zwischenfrequenzsignals eines Audio-Empfangers einer Rundfunkempfangsvorrichtung, bei dem ein Signalparameter eines auf einer Empfangsfrequenz empfangenen Nutzsignals des Audio-Empfängers ermittelt und berücksichtigt wird. Die Erfindung betrifft außerdem eine entsprechende Rundfunkempfangsvorrichtung mit einem Audio-Empfänger zum Empfangen eines Nutzsignals auf einer Empfangsfrequenz, einer Zwischenfrequenzfiltereinheit zur Filterung eines dem Nutzsignal entsprechenden Zwischenfrequenzsignals und einer Filterauswahleinheit zur Auswahl einer Durchlaßbandbreite für die Zwischenfrequenzfiltereinheit des Audio-Empfängers.

Bei derartigen Rundfunkempfangsvorrichtungen wird das Nutzsignal in einem Eingangskreis des Audio-Empfängers mittels einer Antenne empfangen, vorverstärkt und in einem Mischerkreis zu einem Zwischenfrequenzsignal umgewandelt, so daß das Nutzsignal beispielsweise als Frequenzmodulation einer Zwischenfrequenz von 10,7 MHz vorliegt. Das Zwischenfrequenzsignal wird verstärkt und in der Zwischenfrequenzfiltereinheit mit einer bestimmten Durchlaßbandbreite siebgefiltert.

Bekannte Rundfunkempfangsvorrichtungen besitzen zur Auswahl der Durchlaßbandbreite der Zwischenfrequenzfilterung eine Filterauswahleinheit, in der ein geeigneter Signalparameter des Nutzsignals ermittelt wird und in Abhängigkeit hiervon eine entsprechende Durchlaßbandbreite in der Zwischenfrequenzfiltereinheit eingestellt wird. Falls beispielsweise eine geringere Empfangsqualität festgestellt wird, wird eine geringere Durchlaßbandbreite ausgewählt, um dem Nutzsignal frequenzmäßig benachbarte Störsignale herauszufiltern.

Diese Filterung mit engerer Durchlaßbandbreite verringert zwar den Einfluß derartiger Störsignale und verbessert somit die Selektivität, sie führt jedoch auch zu einer Verschlechterung anderer Parameter, wie beispielsweise der Stereo-Kanaltrennung. Daher veranlaßt die Filterauswahleinheit die Verwendung einer größeren Durchlaßbandbreite, sobald eine höhere Empfangsqualität detektiert wird. Da die Verbesserung der Empfangsqualität jedoch durch die zuvor veranlaßte Verwendung einer engeren Durchlaßbandbreite bewirkt sein kann, kann dieser Regelmechanismus zu einem hörbaren und somit nachteiligen ständigen Wechsel zwischen den verschiedenen zur Verfügung stehenden Filtern führen.

Es ist eine Aufgabe der Erfindung, ein Verfahren zum Steuern der Durchlaßbandbreite bei der Zwischenfrequenzfilterung zu schaffen, bei dem ein verfahrensbedingter ständiger Wechsel zwischen verschiedenen Durchlaßbandbreiten vermieden wird.

Diese Aufgabe wird für ein Verfahren der eingangs genannten Art dadurch gelöst, daß ein Signalparameter wenigstens eines Nachbarsignals ermittelt wird, das auf einer der Empfangsfrequenz benachbarten Nachbarfrequenz empfangen wird, und daß in Abhängigkeit zumindest von dem aus dem Nutzsignal ermittelten Signalparameter, dem aus dem Nachbarsignal ermittelten Signalparameter und dem Frequenzabstand zwischen Empfangsfrequenz und Nachbarfrequenz die Durchlaßbandbreite der Zwischenfrequenzfilterung ausgewählt wird.

Erfindungsgemäß ist also vorgesehen, für die Berechnung und Einstellung der Durchlaßbandbreite nicht nur einen dem Audio-Nutzsignal zugeordneten Signalparameter, sondern wenigstens auch einen solchen Signalparameter zu ermitteln und zu berücksichtigen, welcher einem störenden Nachbarsignal auf einer anderen, zu der Empfangsfrequenz des Nutzsignals benachbarten Nachbarfrequenz zugeordnet ist.

Im Rahmen dieser Erfindung ist als Signalparameter des Nutzsignals ein solcher aus dem Nutzsignal ermittelbarer Parameter zu verstehen, der zumindest indirekt eine Aussage über die Qualität des Signalempfangs im Audio-Empfänger oder über die Anwesenheit von unerwünschten Störeinflüssen erlaubt. Als ein derartiger Signalparameter kommen beispielsweise der Signalpegel oder die Signalstärke des Nutzsignals, insbesondere in Form der elektrischen Feldstärke, oder der Hub des Nutzsignals in Betracht. Ein weiterer möglicher Signalparameter des Nutzsignals kann durch ein Ausgangssignal eines zugeordneten Empfangsqualitätsdetektors gegeben sein, insbesondere durch ein sog. ultra-sonic-noise(USN)-Signal, welches Aufschluß über das Vorhandensein von Nachbarsignalen gibt.

Als Signalparameter des Nachbarsignals ist im Sinne dieser Erfindung ein Parameter zu verstehen, der eine Aussage über die Stärke des zugeordneten Nachbarsignals und dementsprechend über die Eignung des Nachbarsignals zur Störbeeinflussung des Nutzsignals liefern kann. Als derartiger Parameter des störenden Signals können beispielsweise die Signalstärke, insbesondere die elektrische Feldstärke oder der Hub des Nachbarsignals herangezogen werden.

Bei dem erfindungsgemäßen Verfahren kann ein unbeabsichtigter ständiger Wechsel zwischen verschiedenen Filtern bzw. Filterbandbreiten leichter vermieden werden, da mit dem betreffenden Signalparameter des Nachbarsignals grundsätzlich ein Auswahlkriterium herangezogen werden kann, das durch einen Wechsel der Durchlaßbandbreite für das Nutzsignal nicht beeinflußt wird. Aufgrund dieses zusätzlich zur Verfügung stehenden Auswahlkriteriums kann außerdem als Signalparameter des Nutzsignals ein Kriterium herangezogen werden, das - verglichen mit der bei bekannten Verfahren berücksichtigten Empfangsqualität - durch einen Wechsel der Durchlaßbandbreite der Zwischenfrequenzfilterung nicht oder lediglich unwesentlich beeinflußt wird.

Somit wird eine direkte Rückkopplung zwischen der ausgewählten Durchlaßbandbreite einerseits und den ermittelten Signalparametern andererseits weitestgehend vermieden, und der bekannte Regelmechanismus wird durch eine stabile Steuerung ersetzt.

Die Ermittlung der jeweiligen Signalparameter von Nutzsignal bzw. Nachbarsignal kann besonders wirkungsvoll erfolgen, wenn das betreffende Signal bereits zu einem Zwischenfrequenzsignal umgeformt und als solches verstärkt und gefiltert sowie insbesondere wieder demoduliert worden ist.

Um auf Grundlage der erläuterten Signalparameter von Nutzsignal und Nachbarsignal eine entsprechende Durchlaßbandbreite der Zwischenfrequenzfilterung auszuwählen, können diese Signalparameter relativ zueinander verglichen werden. Insbesondere ist es möglich, die jeweiligen charakteristischen Werte miteinander zu verrechnen, beispielsweise zu subtrahieren, zu addieren und/oder zu dividieren, und hierbei mit unterschiedlichen Gewichtungsfaktoren zu versehen.

Vorzugsweise wird die Durchlaßbandbreite grundsätzlich um so enger gewählt, je größer das Verhältnis von Signalstärke des Nachbarsignals zur Signalstärke des Nutzsignals und/oder je geringer der Abstand zwischen Empfangsfrequenz und Nachbarfrequenz ist.

Weiterhin ist es bevorzugt, wenn das Nachbarsignal mittels eines eigenen Zusatz-Empfängers ermittelt wird, dessen Empfangsfrequenz, d.h. die Nachbarfrequenz, unabhängig von der in dem Audio-Empfänger eingestellten Empfangsfrequenz eingestellt werden kann. Auf diese Weise kann der Zusatz-Empfänger ständig verschiedene Nachbarfrequenzen überprüfen, so daß die aktuelle Einstellung der Durchlaßbandbreite der Zwischenfrequenzfilterung laufend überprüft und gegebenenfalls korrigiert werden kann, ohne daß der Audio-Empfänger seinen Empfang auf der Empfangsfrequenz hierfür unterbrechen muß.

Falls die Signalparameter des Nachbarsignals in entsprechend kurzer Zeit ermittelt werden können, ist es grundsätzlich jedoch auch möglich, die für die Auswahl der Durchlaßbandbreite erforderlichen Nachbarsignale mittels des Audio-Empfängers zu empfangen, indem dieser ständig für kurze Zeit und somit für den Zuhörer nicht wahrnehmbar von der Empfangsfrequenz auf die betreffende Nachbarfrequenz und zurück wechselt.

Falls das Nachbarsignal mittels eines Zusatz-Empfängers ermittelt wird, ist es bevorzugt, wenn dieser als Daten-Empfänger ausgebildet ist, so daß mittels des Zusatz-Empfängers digital kodierte Rundfunkdaten, insbesondere RDS-Signale, aller verfügbaren Rundfunksender ausgewertet werden können. Diese Rundfunkdaten können für die im Audio-Empfänger eingestellte Empfangsfrequenz, für alternative Empfangsfrequenzen des im Audio-Empfänger eingestellten Rundfunkprogramms oder für andere Rundfunkprogramme ermittelt, ausgewertet und/oder für den Fall eines nachfolgenden manuellen Wechsels des Rundfunkprogramms bereitgehalten werden.

Insbesondere ist es möglich, die Bitfehlerrate eines RDS-Signals, das von dem Zusatz-Empfänger oder von dem Audio-Empfänger empfangen worden ist, als zusätzliches Kriterium für die Auswahl einer Zwischenfrequenz-Durchlaßbandbreite zu berücksichtigen.

Selbstverständlich ist es möglich, viele verschiedene Nachbarfrequenzen zu überprüfen. Der jeweils ermittelte Signalparameter eines Nachbarsignals kann beispielsweise derart berücksichtigt werden, daß nach jeder Einstellung einer neuen Nachbarfrequenz überprüft wird, ob der Störeinfluß des entsprechenden Nachbarsignals eine Änderung der aktuell eingestellten Durchlaßbandbreite der Zwischenfrequenzfilterung erforderlich macht. Hierfür kann ein aktueller Wert des betreffenden Signalparameters des Nutzsignals ermittelt werden. Außerdem kann zwischen derartigen Überprüfungen verschiedener Nachbarfrequenzen auch erneut überprüft werden, ob diejenigen Signalparameter von Nutzsignal und Nachbarsignal, die dem zuletzt vorgenommenen Wechsel der Durchlaßbandbreite zugrunde lagen, immer noch wertemäßig aktuell sind. Bei diesen Überprüfungen können vorbestimmte Toleranzgrenzen berücksichtigt werden.

Die Überprüfung von verschiedenen Nachbarsignalen bzw. Nachbarfrequenzen ist vorzugsweise auf ein begrenztes Frequenzband in der Umgebung der Empfangsfrequenz des Nutzsignals limitiert. Beispielsweise kann bei Ultrakurzwellen-Empfang diese Überprüfung in Frequenzschritten von 100 kHz erfolgen, und zwar in einer Frequenzumgebung von ± 300 kHz bezüglich der Empfangsfrequenz des Nutzsignals.

Um eine für die Zwischenfrequenzfilterung ausgewählte Durchlaßbandbreite einzustellen, kann eines mehrerer zur Verfügung stehender Filter unterschiedlicher Durchlaßbandbreite aktiviert werden, oder es können die Filtereigenschaften eines Digitalfilters quasi-kontinuierlich in kleinen Schritten und innerhalb vorbestimmter Extrem-Grenzwerte verändert werden. Es ist möglich, das Zwischenfrequenzsignal in Abhängigkeit von dem Ergebnis der erläuterten Überprüfungen asymmetrisch, d.h. in positiver und negativer Frequenzumgebung des Nutzsignals mit unterschiedlicher Bandbreite zu filtern.

Es ist eine weitere Aufgabe der Erfindung, eine Rundfunkempfangsvorrichtung zu schaffen, bei der ein durch Rückkopplungseffekte bedingter ständiger Wechsel zwischen verschiedenen Durchlaßbandbreiten in der Zwischenfrequenzfiltereinheit vermieden wird.

Diese Aufgabe wird für eine Rundfunkempfangsvorrichtung der eingangs genannten Art dadurch gelöst, daß ein von dem Audio-Empfänger im wesentlichen unabhängiger Zusatz-Empfänger zum Empfang eines Nachbarsignals auf einer der Empfangsfrequenz des Audio-Empfängers benachbarten Nachbarfrequenz vorgesehen ist, daß durch die Filterauswahleinheit ein Signalparameter des Nachbarsignals des Zusatz-Empfängers und ein Signalparameter des Nutzsignals des Audio-Empfängers ermittelbar sind, daß die Filterauswahleinheit eine Signalverarbeitungseinrichtung zum Verrechnen zumindest des Signalparameters des Nutzsignals, des Signalparameters des Nachbarsignals und des Frequenzabstands zwischen Empfangsfrequenz und Nachbarfrequenz miteinander aufweist, und daß in Abhängigkeit von einem Ausgangssignal der Signalverarbeitungseinrichtung die Durchlaßbandbreite der Zwischenfrequenzfiltereinheit des Audio-Empfängers auswählbar ist.

Durch die Vorsehung eines eigenen Zusatz-Empfängers und einer Filterauswahleinheit zur Ermittlung und entsprechenden Verarbeitung der Signalparameter von Nutzsignal und Nachbarsignal können die im Zusammenhang mit dem erfindungsgemäßen Verfahren bereits erläuterten Vorteile erzielt werden.

Die Rundfunkempfangsvorrichtung kann entsprechend den erläuterten Ausführungsformen des erfindungsgemäßen Verfahrens ausgebildet sein. Insbesondere kann die Filterauswahleinheit eine Frequenzbestimmungseinrichtung zur Bestimmung des Abstands zwischen Empfangsfrequenz und Nachbarfrequenz aufweisen. Die Signalverarbeitungseinrichtung kann durch einen Mikroprozessor gebildet sein.

Weitere bevorzugte Ausführungsformen des erfindungsgemäßen Verfahrens und der erfindungsgemäßen Vorrichtung sind in den jeweiligen Unteransprüchen aufgeführt. Die Erfindung wird nachfolgend beispielhaft anhand der Zeichnungen beschrieben; in diesen zeigen:
- Fig. 1 und 2: schematische Darstellungen zweier Ausführungsformen der erfindungsgemäßen Rundfunkempfangsvorrichtung,
- Fig. 3: eine Änderung der Durchlaßbandbreite der Zwischenfrequenzfilterung eines Nutzsignals in Anwesenheit eines störenden Nachbarsignals, und
- Fig. 4: ein Flußdiagramm von Schritten des erfindungsgemäßen Verfahrens.

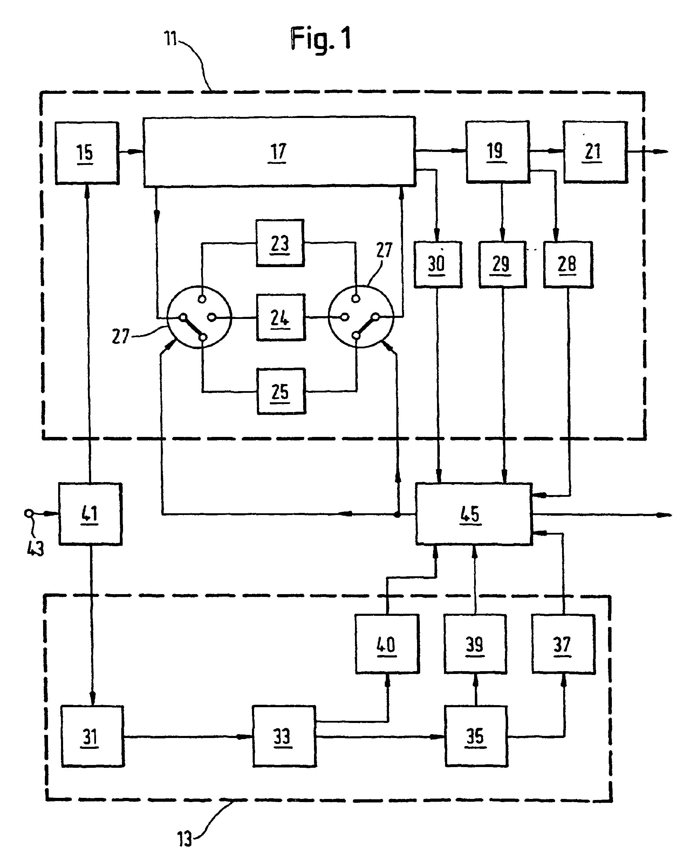

Fig. 1 zeigt schematisch Teile einer erfindungsgemäßen Rundfunkempfangsvorrichtung mit einem Audio-Empfänger 11 zum Empfang eines Audio-Nutzsignals auf einer eingestellten Empfangsfrequenz sowie mit einem Zusatz-Empfänger 13 zum Empfang eines Nachbarsignals. Der Audio-Empfänger 11 weist eine Eingangs- und Mischerstufe 15, eine Zwischenfrequenzstufe 17, einen Demodulator 19 und eine Audiostufe 21 auf, die jeweils einander nachgeschaltet sind. Die Zwischenfrequenzstufe 17 besitzt drei Siebfilter 23, 24, 25 unterschiedlicher Durchlaßbandbreite, von denen jeweils genau eines mittels Schalter 27 zwischengeschaltet werden kann.

Jeweils ein Ausgang des Demodulators 19 ist mit einer RDS-Dekodiereinheit 28 und einem Empfangsqualitätsdetektor 29 verbunden. Außerdem ist der Zwischenfrequenzstufe 17 ein Pegeldetektor 30 zur Ermittlung eines Signalpegels des Zwischenfrequenz-Nutzsignals nachgeschaltet. Der jeweilige Ausgang des Pegeldetektors 30, des Empfangsqualitätsdetektors 29 und der RDS-Dekodiereinheit 28 ist an einen Mikroprozessors 45 angeschlossen.

Der Zusatz-Empfänger 13 besitzt - jeweils einander nachgeschaltet - eine Eingangs- und Mischerstufe 31, eine Zwischenfrequenzstufe 33, einen Demodulator 35 und eine RDS-Dekodiereinheit 37. Ferner sind ein Empfangsqualitätsdetektor 39 dem Demodulator 35 und ein Pegeldetektor 40 der Zwischenfrequenzstufe 33 nachgeschaltet. Der jeweilige Ausgang des Pegeldetektors 40, des Empfangsqualitätsdetektors 39 und der RDS-Dekodiereinheit 37 ist mit dem Mikroprozessors 45 verbunden.

Außerdem besitzt die dargestellte Rundfunkempfangsvorrichtung eine Verzweigungseinheit 41, die eingangsseitig mit einer Empfangsantennenbuchse 43 und ausgangsseitig zum einen mit der Eingangs- und Mischerstufe 15 des Audio-Empfängers 11 und zum anderen mit der Eingangs- und Mischerstufe 31 des Zusatz-Empfängers 13 verbunden ist. Ferner ist in Fig. 1 gezeigt, daß ein Ausgang des Mikroprozessors 45 mit den Schaltern 27 der Zwischenfrequenzstufe 17 verbunden ist und ein weiterer Ausgang am Mikroprozessor 45 zur Weiterleitung der erhaltenen oder berechneten Daten, insbesondere der RDS-Daten, vorgesehen ist.

Im folgenden wird die Funktionsweise der in Fig. 1 gezeigten Vorrichtung erläutert.

Von einer nicht dargestellten, mit der Buchse 43 verbundenen Empfangsantenne aufgenommene Rundfunksignale werden in der Verzweigungseinheit 41 geteilt und jeweils an die Eingangs- und Mischerstufe 15, 31 des Audio-Empfängers 11 bzw. des Zusatz-Empfängers 13 übertragen. Dort werden der Empfangsfrequenz bzw. der Nachbarfrequenz entsprechende Rundfunksignale vorverstärkt und in einem Mischerkreis zu Zwischenfrequenzsignalen umgewandelt, in denen die in dem jeweiligen Rundfunksignal enthaltene Information als Frequenzmodulation einer Zwischenfrequenz-Trägerwelle enthalten ist. In der nachfolgenden Zwischenfrequenzstufe 17 bzw. 33 wird das Zwischenfrequenzsignal verstärkt und gefiltert, wobei in dem Audio-Empfänger 11 die drei Filter 23, 24, 25 zur Verfügung stehen.

Danach wird das jeweilige Zwischenfrequenzsignal zum einen in dem zugeordneten Demodulator 19 bzw. 35 demoduliert. Zum anderen wird das Zwischenfrequenzsignal von der betreffenden Zwischenfrequenzstufe 17, 33 an den zugeordneten Pegeldetektor 30 bzw. 40 geleitet, der aus dem Zwischenfrequenz-Nutzsignal bzw. aus dem Zwischenfrequenz-Nachbarsignal die jeweils empfangene Feldstärke bestimmt. Außerdem ermitteln die beiden Empfangsqualitätsdetektoren 29 und 39 aus den Ausgangssignalen des jeweils vorgeschalteten Demodulators 19 bzw. 35 ein eventuell enthaltenes ultra-sonic-noise (USN)-Signal. Den empfangenen Feldstärken und den ermittelten USN-Signalen entsprechende Werte werden von den betreffenden Detektoren 30, 40 bzw. 29, 39 an den Mikroprozessor 45 übermittelt.

In der Audiostufe 21 des Audio-Empfängers 11 wird die in dem demodulierten Signal enthaltene Audio-Information gewonnen und weitergeleitet. Außerdem wird in der RDS-Dekodiereinheit 28 des Audio-Empfängers 11 eine dem Nutzsignal zugeordnete RDS-Information ermittelt und an den Mikroprozessor 45 weitergeleitet. In dem Zusatzempfänger 13 liest die RDS-Dekodiereinheit 37 die RDS-Information aus dem demodulierten Signal und übermittelt diese an den Mikroprozessor 45 weiter.

Der Mikroprozessor 45 überprüft, ob eine neue Durchlaßbandbreite für die Filterung des Nutzsignals innerhalb der Zwischenfrequenzstufe 17 des Audio-Empfängers 11 erforderlich ist, und veranlaßt gegebenenfalls mittels der Schalter 27 die Zwischenschaltung desjenigen Filters 23, 24 oder 25, welches einer neu ausgewählten Durchlaßbandbreite entspricht. Diese Überprüfung und Auswahl einer Durchlaßbandbreite erfolgt innerhalb des Mikroprozessors 45 in Abhängigkeit von den von den Detektoren 30 bzw. 40 ermittelten Werten der Feldstärken des Nutzsignals und des Nachbarsignals, von dem Nutzsignal und dem Nachbarsignal entsprechenden USN-Signalwerten, von der aus dem Signal der RDS-Dekodiereinheit 28 ermittelten Bitfehlerrate des Nutzsignals sowie von dem Abstand zwischen der Frequenz des Nutzsignals und jener des Nachbarsignals.

Während die Empfangsfrequenz des Audio-Empfängers 11 grundsätzlich konstant bleibt, sofern der Benutzer keinen Wechsel veranlaßt oder - im Falle eines RDS-Systems - nicht automatisch auf eine alternative Frequenz desselben Rundfunkprogramms umgeschaltet wird, werden mittels des Mikroprozessors 45 an der Eingangs- und Mischerstufe 31 des Zusatz-Empfängers 13 entweder in regelmäßigen Zeitabständen oder im wesentlichen ständig neue Nachbarfrequenzen in der Umgebung der Empfangsfrequenz des Audio-Empfängers 11 eingestellt. Die in dem Mikroprozessor 45 von den Pegeldetektoren 30 und 40, den Empfangsqualitätsdetektoren 29 und 39 sowie von den Dekodiereinheiten 28 und 37 berücksichtigten Informationen betreffen also zum einen die an der Eingangs- und Mischerstufe 15 des Audio-Empfängers 11 eingestellte Nutzsignal-Empfangsfrequenz und zum anderen die regelmäßig oder laufend variierte Empfangsfrequenz des Zusatz-Empfängers 13, d.h. die Nachbarfrequenz.

Zu dem Aufbau gemäß Fig. 1 ist anzumerken, daß beispielsweise der Empfangsqualitätsdetektor 39 des Zusatz-Empfängers 13 nicht zwingend erforderlich ist, und daß zur Verwirklichung der Erfindung bei besonders einfachem Aufbau auch auf den Empfangsqualitätsdetektor 29 und die RDS- Dekodiereinheit 28 des Audio-Empfängers 11 verzichtet werden kann.

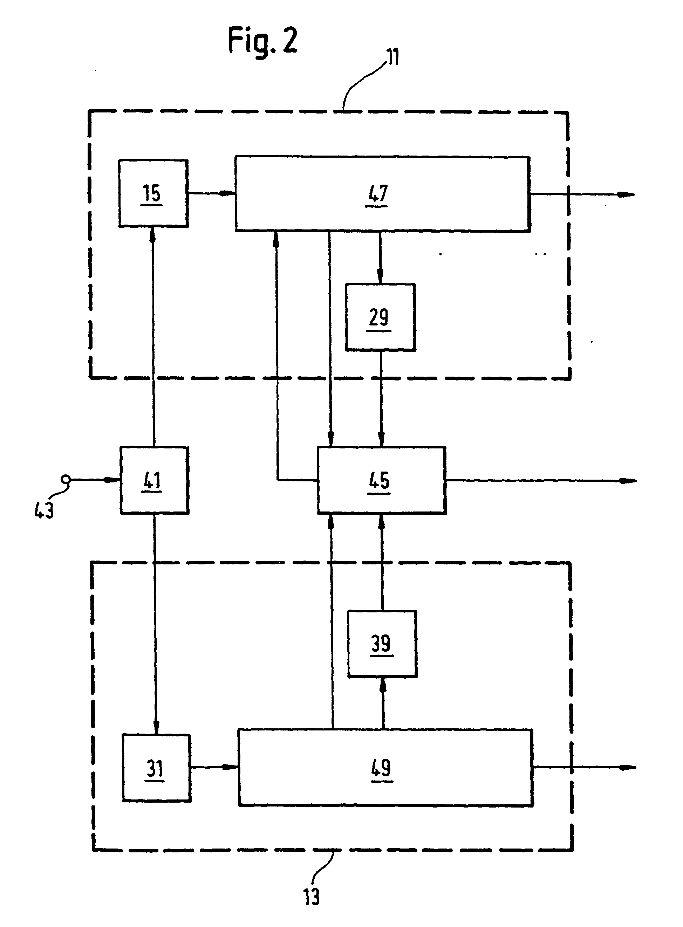

Fig. 2 zeigt schematisch eine weitere Ausführungsform der erfindungsgemäßen Rundfunkempfangsvorrichtung. Diejenigen Teile mit im wesentlichen gleichem Aufbau und gleicher Funktion wie bei der Ausführungsform gemäß Fig. 1 sind mit denselben Bezugszeichen versehen. Im Unterschied zu der Ausführungsform gemäß Fig. 1 sind in dem Audio-Empfänger 11 die Zwischenfrequenzstufe 17 einschließlich der Filter 23, 24, 25 und der Schalter 27, sowie der Demodulator 19, die Audiostufe 21, der Pegeldetektor 30 und die RDS-Dekodiereinheit 28 innerhalb einer digitalen Signalverarbeitungseinheit 47 integriert. Das Zwischenfrequenzsignal wird hier also mittels eines von dem Mikroprozessor 45 angesteuerten Digitalfilters gefiltert, wobei die Durchlaßbandbreite des Digitalfilters innerhalb eines vorbestimmten Minimal- und Maximalwertes in einer Vielzahl von Abstufungen verändert werden kann.

Die analoge Zwischenfrequenzstufe 33, der Pegeldetektor 40, der Demodulator 35 und die RDS-Dekodiereinheit 37 des Zusatz-Empfängers 13 der in Fig. 1 dargestellten Vorrichtung sind bei der Ausführungsform gemäß Fig. 2 ebenfalls durch eine digitale Signalverarbeitungseinheit 49 ersetzt.

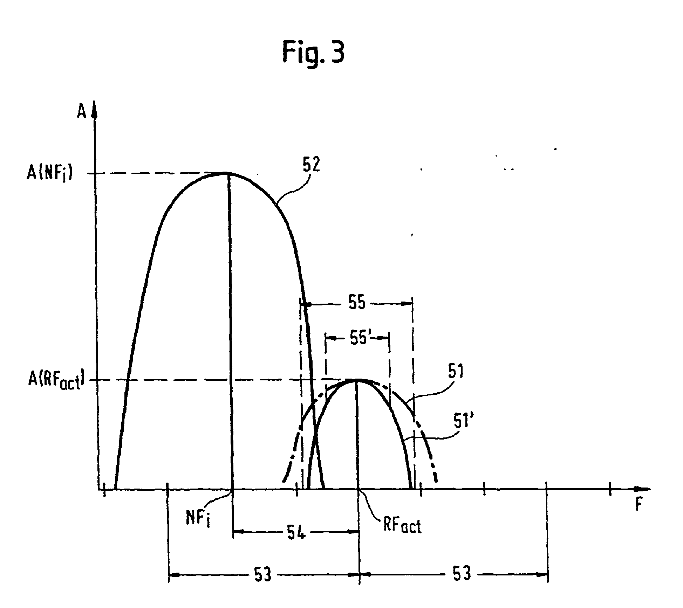

Das Funktionsprinzip der Erfindung wird anhand der Fig. 3 näher erläutert. Diese zeigt eine mögliche Veränderung der Zwischenfrequenz-Bandbreite in Anwesenheit eines störenden Senders. Jeweils als Amplitude A in Abhängigkeit von der eingestellten Frequenz F angetragen sind ein Amplitudenverlauf 51 des Nutzsignals bei größerer Filterbandbreite, ein Amplitudenverlauf 51' des Nutzsignals bei engerer Filterbandbreite sowie ein Amplitudenverlauf 52 des Nachbarsignals. Diese Amplituden entsprechen beispielsweise dem Signalpegel oder der Feldstärke des betreffenden Signals, wie sie von den Pegeldetektoren 30, 40 der Rundfunkempfangsvorrichtung gemäß Fig. 1 ermittelt werden können. Eine beispielsweise in dem Audio-Empfänger 11 gemäß Fig. 1 und 2 für das Nutzsignal aktuell eingestellte Empfangsfrequenz RF_{act} und der hierzu innerhalb der Amplitudenverläufe 51, 51' entsprechende Maximalwert der Signalamplitude A(RF_{act}) sind in Fig. 3 dargestellt.

In bestimmten Frequenzschritten innerhalb jeweils eines Frequenzbereichs 53 oberhalb und unterhalb der aktuellen Empfangsfrequenz RF_{act} wird die Signalamplitude von Störsignalen ermittelt, beispielsweise mittels des Zusatz-Empfängers 13 gemäß Fig. 1 und 2. Eine derartig untersuchte Nachbarfrequenz NFᵢ sowie der entsprechende Wert der Amplitude A(NFᵢ) sind ebenfalls in Fig. 3 gezeigt. In dem dargestellten Beispiel entspricht die Nachbarfrequenz NFᵢ gerade der Ausstrahlfrequenz eines anderen als des eingestellten Rundfunkprogramms, mit einer wesentlich höheren Amplitude A(NFᵢ) als der Amplitude A(RF_{act}) des Nutzsignals.

Anhand der ermittelten Werte der Signalamplituden A(RF_{act}) und A(NFᵢ) sowie anhand des Abstands 54 zwischen den beiden Frequenzen RF_{act} und NFᵢ wird für die Zwischenfrequenzfilterung des betreffenden Audio-Empfängers eine Durchlaßbandbreite 55 oder 55' bestimmt, wie in Fig. 3 schematisch dargestellt. Da die Amplitude A(NFᵢ) des störenden Nachbarsignals bezüglich der Amplitude A(RF_{act}) des aktuell eingestellten Nutzsignals vergleichsweise hoch ist, kann ausgehend von der Durchlaßbandbreite 55 eine engere Durchlaßbandbreite 55' ausgewählt und eingestellt werden. Dementsprechend verschmälert sich der Amplitudenverlauf 51' des Nutzsignals gegenüber dem vorherigen Verlauf 51, und der Überlapp mit dem Amplitudenverlauf 52 des störenden Nachbarsignals verringert sich.

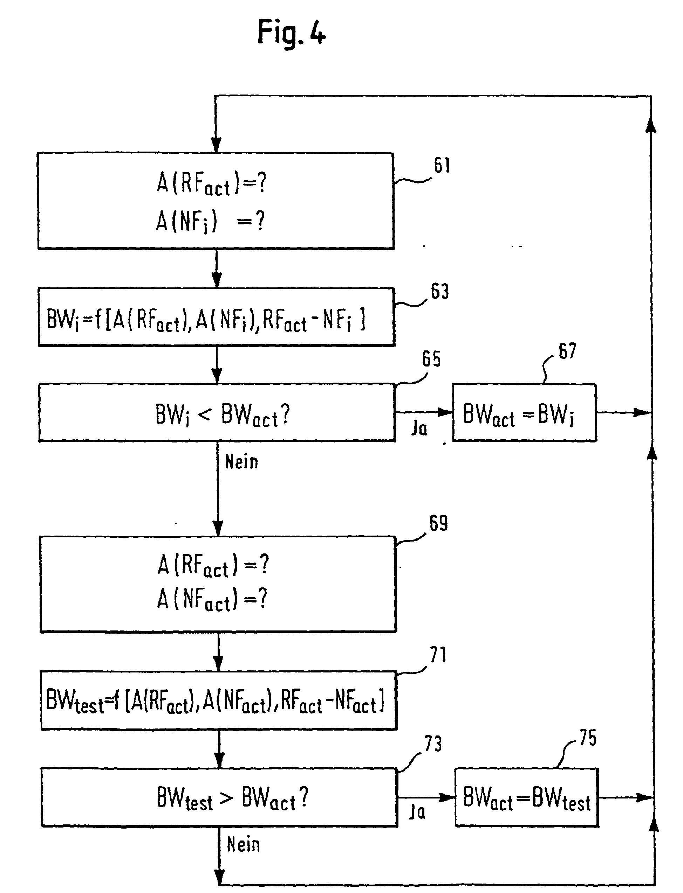

Fig. 4 zeigt als Flußdiagramm eine mögliche Implementierung des erfindungsgemäßen Verfahrens. Nachdem in einem Audio-Empfänger auf einer aktuellen Empfangsfrequenz RF_{act} ein Nutzsignal und auf einer hierzu benachbarten Nachbarfrequenz NFᵢ ein Nachbarsignal empfangen worden sind, wird überprüft, ob die entsprechenden Empfangsbedingungen eine Verringerung der aktuell eingestellten Durchlaßbandbreite BW_{act} notwendig machen.

Hierfür wird in einem Parameterermittlungsschritt 61 ein jeweiliger Signalparameter A(RF_{act}) bzw. A(NFᵢ), beispielsweise ein dem empfangenen Signalpegel entsprechender Wert, festgestellt. In einem nachfolgenden Bandbreitenbestimmungsschritt 63 wird als Funktion dieser Werte sowie der Differenz zwischen der aktuell eingestellten Empfangfrequenz RF_{act} und der betrachteten Nachbarfrequenz NFᵢ eine Durchlaßbandbreite BWᵢ für die Zwischenfrequenzfilterung des Nutzsignals berechnet.

In einem sich hieran anschließenden Prüfungsschritt 65 wird geprüft, ob die berechnete Durchlaßbandbreite BWᵢ kleiner ist als die für die Zwischenfrequenzfilterung aktuell eingestellte, auf einer früheren Berechnung basierenden Bandbreite BW_{act}. Zutreffendenfalls wir in einem Einstellschritt 67 als neue Durchlaßbandbreite BW_{act} die zuvor berechnete, geringere Bandbreite BWᵢ eingestellt.

Falls dagegen der Prüfungsschritt 65 ein negatives Resultat ergibt, werden in einem Parameterermittlungsschritt 69 ein aktueller Wert des Signalparameters A(RF_{act}) des Nutzsignals auf der im Audio-Empfänger eingestellten Frequenz RF_{act} sowie ein aktueller Wert des Signalparameters A(NF_{act}) des Nachbarsignals auf jener Nachbarfrequenz NF_{act} ermittelt, welche der vorherigen Berechnung der aktuell verwendeten Durchlaßbandbreite BW_{act} zugrunde gelegt worden war. Mit anderen Worten soll jetzt überprüft werden, ob die aktuell eingestellte Bandbreite BW_{act} überhaupt noch erforderlich ist.

Hierzu wird in einem nachfolgenden Bandbreitenbestimmungsschritt 71 auf Grundlage der neuerlich ermittelten Signalparameter A(RF_{act}) und A(NF_{act}) sowie des entsprechenden Frequenzabstands RF_{act}-NF_{act} eine Vergleichs-Bandbreite Brust berechnet. In einem Prüfungsschritt 73 wird danach geprüft, ob diese Vergleichs-Bandbreite BWₜₑₛₜ größer ist als die aktuell eingestellte Bandbreite BW_{act}.

Falls dies der Fall ist, kann in einem Einstellschritt 75 als aktuelle Bandbreite BW_{act} wieder ein größerer Wert, nämlich die Vergleichs-Bandbreite BWₜₑₛₜ eingestellt werden. Anderenfalls wird der aktuelle Wert BW_{act} beibehalten.

Nach dem Prüfungsschritt 73 oder gegebenenfalls nach dem Einstellschritt 67 oder dem Einstellschritt 75 kann dieses Verfahren mit dem Parameterermittlungsschritt 61 neu begonnen werden, wobei eine neue Nachbarfrequenz NFi gewählt wird. Auf diese Weise wird die Durchlaßbandbreite der Zwischenfrequenzfilterung in bestimmten Zeitabständen aktualisiert.

### Bezugszeichenliste

- 11: Audio-Empfänger
- 13: Zusatz-Empfänger
- 15: Eingangs- und Mischerstufe
- 17: Zwischenfrequenzstufe
- 19: Demodulator
- 21: Audiostufe
- 23: Filter
- 24: Filter
- 25: Filter
- 27: Schalter
- 28: RDS-Dekodiereinheit
- 29: Empfangsqualitätsdetektor
- 30: Pegeldetektor
- 31: Eingangs- und Mischerstufe
- 33: Zwischenfrequenzstufe
- 35: Demodulator
- 37: RDS-Dekodiereinheit
- 39: Empfangsqualitätsdetektor
- 40: Pegeldetektor
- 41: Verzweigungseinheit
- 43: Empfangsantennenbuchse
- 45: Mikroprozessor
- 47: digitale Signalverarbeitungseinheit
- 49: digitale Signalverarbeitungseinheit
- 51: Amplitudenverlauf des Nutzsignals bei größerer Filterbandbreite
- 51': Amplitudenverlauf des Nutzsignals bei engerer Filterbandbreite
- 52: Amplitudenverlauf des Nachbarsignals
- 53: Frequenzbereich
- 54: Frequenzabstand
- 55: größere Durchlaßbandbreite
- 55': engere Durchlaßbandbreite
- 61: Parameterermittlungsschritt
- 63: Bandbreitenbestimmungsschritt
- 65: Prüfungsschritt
- 67: Einstellschritt
- 69: Parameterermittlungsschritt
- 71: Bandbreitenbestimmungsschritt
- 73: Prüfungsschritt
- 75: Einstellschritt

## Patentansprüche

1. Verfahren zum Steuern der Durchlaßbandbreite (55, 55') beim Filtern eines Zwischenfrequenzsignals eines Audio-Empfängers (11) einer Rundfunkempfangsvorrichtung,
bei dem ein Signalparameter eines auf einer Empfangsfrequenz empfangenen Nutzsignals des Audio-Empfängers (11) ermittelt und berücksichtigt wird,
**dadurch gekennzeichnet,**
**daß** ein Signalparameter wenigstens eines Nachbarsignals ermittelt wird, das auf einer der Empfangsfrequenz benachbarten Nachbarfrequenz empfangen wird (61, 69), und
**daß** in Abhängigkeit zumindest von dem aus dem Nutzsignal ermittelten Signalparameter, dem aus dem Nachbarsignal ermittelten Signalparameter und dem Frequenzabstand (54) zwischen Empfangsfrequenz und Nachbarfrequenz die Durchlaßbandbreite (55, 55') der Zwischenfrequenzfilterung ausgewählt wird (63, 71).

2. Verfahren nach Anspruch 1,
**dadurch gekennzeichnet,**
**daß** als Signalparameter des Nutzsignals die Signalstärke des Nutzsignals, der Hub des Nutzsignals und/oder ein Ausgangssignal eines dem Nutzsignal zugeordneten Empfangsqualitätsdetektors (29, 39), insbesondere ein ultra-sonic-noise (USN)-Signal, berücksichtigt wird.

3. Verfahren nach einem der vorhergehenden Ansprüche,
**dadurch gekennzeichnet,**
**daß** als Signalparameter des Nachbarsignals die Signalstärke des Nachbarsignals und/oder der Hub des Nachbarsignals berücksichtigt wird.

4. Verfahren nach einem der vorhergehenden Ansprüche,
**dadurch gekennzeichnet,**
**daß** vor der Berücksichtigung des jeweiligen Signalparameters des Nutzsignals oder des Nachbarsignals für die Auswahl der Durchlaßbandbreite (55, 55') diese Signale jeweils zu Zwischenfrequenzsignalen gemischt und als Zwischenfrequenzsignale verstärkt werden.

5. Verfahren nach einem der vorhergehenden Ansprüche,
**dadurch gekennzeichnet,**
**daß** zur Auswahl der Durchlaßbandbreite (55, 55') der Zwischenfrequenzfilterung der betreffende Signalparameter des Nutzsignals und der betreffende Signalparameter des Nachbarsignals relativ zueinander verglichen werden.

6. Verfahren nach einem der vorhergehenden Ansprüche,
**dadurch gekennzeichnet,**
**daß** die Durchlaßbandbreite (55, 55') der Zwischenfrequenzfilterung um so enger gewählt wird, je höher die Signalstärke oder der Hub des Nachbarsignals bezüglich des entsprechenden Signalparameters des Nutzsignals und/oder je geringer der Frequenzabstand (54) zwischen Empfangsfrequenz und Nachbarfrequenz ist.

7. Verfahren nach einem der vorhergehenden Ansprüche,
**dadurch gekennzeichnet,**
**daß** das Nachbarsignal mittels eines von dem Audio-Empfänger (11) im wesentlichen unabhängigen Zusatz-Empfängers (13) ermittelt wird.

8. Verfahren nach Anspruch 7,
**dadurch gekennzeichnet,**
**daß** der Zusatz-Empfänger (13) als Daten-Empfänger zum Empfang von digital kodierten Rundfunkdaten, insbesondere RDS-Signalen, ausgebildet ist.

9. Verfahren nach einem der vorhergehenden Ansprüche,
**dadurch gekennzeichnet,**
**daß** die Durchlaßbandbreite (55, 55') der Zwischenfrequenzfilterung zusätzlich in Abhängigkeit von der Bitfehlerrate eines auf der Empfangsfrequenz empfangenen RDS-Signals ausgewählt wird.

10. Verfahren nach einem der vorhergehenden Ansprüche,
**dadurch gekennzeichnet,**
**daß** für mehrere verschiedene Nachbarfrequenzen das jeweilige Nachbarsignal und ein entsprechender Signalparameter ermittelt werden, wobei die mehreren Nachbarfrequenzen vorzugsweise konstante Frequenzabstände zueinander aufweisen.

11. Verfahren nach einem der vorhergehenden Ansprüche,
**dadurch gekennzeichnet,**
**daß** nach jeder Ermittlung eines neuen Nachbarsignals anhand des betreffenden Signalparameters dieses neu ermittelten Nachbarsignals und anhand des Frequenzabstands (54) zwischen der Empfangsfrequenz und der Nachbarfrequenz des neu ermittelten Nachbarsignals eine entsprechende Durchlaßbandbreite (55') der Zwischenfrequenzfilterung bestimmt wird (63); und daß die ausgewählte Durchlaßbandbreite (55) gegebenenfalls entsprechend aktualisiert wird (67).

12. Verfahren nach Anspruch 11,
**dadurch gekennzeichnet,**
**daß** für die Neubestimmung der Durchlaßbandbreite (55') jeweils der zuvor bereits ermittelte und berücksichtigte Signalparameter des Nutzsignals neu ermittelt und berücksichtigt wird.

13. Verfahren nach einem der vorhergehenden Ansprüche,
**dadurch gekennzeichnet,**
**daß** Nachbarsignale innerhalb eines bezüglich des betreffenden Rundfunk-Frequenzbandes begrenzten Frequenz-Teilbereichs (53) in der Umgebung der Empfangsfrequenz des Nutzsignals in regelmäßigen Zeitabständen ermittelt und für eine Neubestimmung der Durchlaßbandbreite (55') berücksichtigt werden, insbesondere Nachbarsignale innerhalb eines Frequenz-Teilbereichs (53) von ± 300 kHz.

14. Verfahren nach einem der vorhergehenden Ansprüche,
**dadurch gekennzeichnet,**
**daß** zur Einstellung der ausgewählten Durchlaßbandbreite (55, 55') der Zwischenfrequenzfilterung ein Filter von mehreren verschiedenen Filtern (23, 24, 25) mit jeweils vorbestimmter Filtereigenschaft aktiviert wird oder die Filtereigenschaften eines Digitalfilters (47) zumindest näherungsweise kontinuierlich verändert werden.

15. Verfahren nach einem der vorhergehenden Ansprüche,
**dadurch gekennzeichnet,**
**daß** bei der Auswahl der Durchlaßbandbreite (55, 55') der Zwischenfrequenzfilterung ein vorbestimmter maximaler und/oder minimaler Grenzwert der Durchlaßbandbreite berücksichtigt wird.

16. Rundfunkempfangsvorrichtung mit
- einem Audio-Empfänger (11) zum Empfangen eines Nutzsignals auf einer Empfangsfrequenz,
- einer Zwischenfrequenzfiltereinheit (17, 47) zur Filterung eines dem Nutzsignal entsprechenden Zwischenfrequenzsignals und
- einer Filterauswahleinheit zur Auswahl einer Durchlaßbandbreite (55, 55') für die Zwischenfrequenzfiltereinheit (17, 47) des Audio-Empfängers (11),
zur Durchführung des Verfahrens nach einem der vorhergehenden Ansprüche,
**dadurch gekennzeichnet,**
**daß** ein von dem Audio-Empfänger (11) im wesentlichen unabhängiger Zusatz-Empfänger (13) zum Empfang eines Nachbarsignals auf einer der Empfangsfrequenz des Audio-Empfängers (11) benachbarten Nachbarfrequenz vorgesehen ist,
**daß** durch die Filterauswahleinheit ein Signalparameter des Nachbarsignals des Zusatz-Empfängers (13) und ein Signalparameter des Nutzsignals des Audio-Empfängers (11) ermittelbar sind,
**daß** die Filterauswahleinheit eine Signalverarbeitungseinrichtung (45) zum Verrechnen zumindest des Signalparameters des Nutzsignals, des Signalparameters des Nachbarsignals und des Frequenzabstands (54) zwischen Empfangsfrequenz und Nachbarfrequenz miteinander aufweist, und
**daß** in Abhängigkeit von einem Ausgangssignal der Signalverarbeitungseinrichtung (45) die Durchlaßbandbreite (55, 55') der Zwischenfrequenzfiltereinheit (17, 47) des Audio-Empfängers (11) auswählbar ist.

17. Rundfunkempfangsvorrichtung nach Anspruch 16,
**dadurch gekennzeichnet,**
**daß** die Filterauswahleinheit eine Frequenzbestimmungseinrichtung zur Bestimmung des Frequenzabstands (54) zwischen der Empfangsfrequenz und der Nachbarfrequenz aufweist.

18. Rundfunkempfangsvorrichtung nach Anspruch 16 oder Anspruch 17,
**dadurch gekennzeichnet,**
**daß** die Signalverarbeitungseinrichtung (45) durch einen Mikroprozessor gebildet ist.

19. Rundfunkempfangsvorrichtung nach einem der Ansprüche 16 bis 18,
**dadurch gekennzeichnet,**
**daß** die Filterauswahleinheit einen dem Audio-Empfänger (11) zugeordneten Pegeldetektor (30), einen dem Zusatz-Empfänger (13) zugeordneten Pegeldetektor (40) und/oder einen dem Audio-Empfänger (11) zugeordneten Empfangsqualitätsdetektor (29) aufweist.

20. Rundfunkempfangsvorrichtung nach einem der Ansprüche 16 bis 19,
**dadurch gekennzeichnet,**
**daß** der Zusatz-Empfänger (13) als ein Daten-Empfänger ausgebildet ist, der zum Empfang von digital kodierten Rundfunkdaten, insbesondere RDS-Signalen, geeignet ist.

21. Rundfunkempfangsvorrichtung nach einem der Ansprüche 16 bis 20,
**dadurch gekennzeichnet,**
**daß** die Zwischenfrequenzfiltereinheit (17, 47) des Audio-Empfängers (11) wenigstens zwei, vorzugsweise drei einzeln aktivierbare Filter (23, 24, 25) unterschiedlicher vorbestimmter Durchlaßbandbreite (55, 55') oder ein Digitalfilter (47) aufweist, dessen Durchlaßbandbreite (55, 55') innerhalb vorbestimmter Grenzen in einer Vielzahl von Abstufungen veränderbar ist.

## Revendications

1. Procédé de contrôle de la largeur de bande passante (55, 55') lors du filtrage d'un signal en fréquence intermédiaire d'un récepteur audio (11) d'un dispositif de réception radio, qui consiste à déterminer et à prendre en compte un paramètre de signal d'un signal utile du récepteur audio reçu sur une fréquence de réception, **caractérisé en ce qu'**on détermine un paramètre de signal d'au moins un signal voisin qui est reçu sur une fréquence voisine proche de la fréquence de réception (61, 69) et **en ce que** la largeur de bande passante (55, 55') du filtrage en fréquence intermédiaire est sélectionnée en fonction au moins du paramètre de signal déterminé à partir du signal utile, du paramètre de signal déterminé à partir du signal voisin et de l'écart de fréquence (54) entre la fréquence de réception et la fréquence voisine (63, 71).

2. Procédé selon la revendication 1, **caractérisé en ce qu'**est pris en compte comme paramètre de signal du signal utile l'intensité de signal du signal utile, l'amplitude du signal utile et/ou un signal de sortie d'un détecteur de la qualité de réception (29, 39) associé au signal utile, en particulier un signal de bruit ultrasonique (ultra sonic noise - USN).

3. Procédé selon une des revendications précédentes, **caractérisé en ce qu'**on prend en compte comme paramètre de signal du signal voisin l'intensité de signal du signal voisin et/ou l'amplitude du signal voisin.

4. Procédé selon une des revendications précédentes, **caractérisé en ce qu'**avant la prise en compte des paramètres de signal respectifs du signal utile ou du signal voisin pour la sélection de la largeur de bande passante (55, 55'), ces signaux sont mélangés en signaux en fréquence intermédiaire et amplifiés sous la forme de signaux en fréquence intermédiaire.

5. Procédé selon une des revendications précédentes, **caractérisé en ce que** pour la sélection de la largeur de bande passante (55, 55') du filtrage en fréquence intermédiaire, le paramètre de signal concerné du signal utile et le paramètre de signal concerné du signal voisin sont comparés l'un à l'autre.

6. Procédé selon une des revendications précédentes, **caractérisé en ce que** la largeur de bande passante (55, 55') du filtrage en fréquence intermédiaire est choisie pour être d'autant plus étroite que l'intensité de signal ou l'amplitude du signal voisin par rapport au paramètre de signal du signal utile est élevé et/ou que l'écart (54) entre la fréquence de réception et la fréquence voisine est réduit.

7. Procédé selon une des revendication précédentes, **caractérisé en ce que** le signal voisin est déterminé au moyen d'un récepteur additionnel (13) essentiellement indépendant du récepteur audio (11).

8. Procédé selon la revendication 7, **caractérisé en ce que** le récepteur additionnel (13) est conçu sous la forme d'un récepteur de données pour la réception de données radio codées numériquement, en particulier des signaux RDS.

9. Procédé selon une des revendications précédentes, **caractérisé en ce que** la largeur de bande passante (55, 55') du filtrage en fréquence intermédiaire est en outre sélectionnée en fonction du taux d'erreur binaire d'un signal RDS reçu sur la fréquence de réception.

10. Procédé selon une des revendications précédentes, **caractérisé en ce qu'**un signal voisin et un paramètre de signal correspondant sont déterminés respectivement pour plusieurs fréquences voisines différentes, lesdites plusieurs fréquences voisines présentant de préférence des écarts de fréquence constants.

11. Procédé selon une des revendications précédentes, **caractérisé en ce qu'**après chaque détermination d'un nouveau signal voisin à l'aide du paramètre de signal concerné de ce signal voisin nouvellement déterminé, et à l'aide de l'écart de fréquence (54) entre la fréquence de réception et la fréquence voisine du signal voisin nouvellement déterminé, on détermine une largeur de bande passante (55') correspondante du filtrage en fréquence intermédiaire (63) ; et **en ce que** la largeur de bande passante (55) sélectionnée est le cas échéant actualisée (67).

12. Procédé selon la revendication 12, **caractérisé en ce que** pour la nouvelle détermination de la largeur de bande passante (55'), on re-détermine et on prend en compte le paramètre de signal du signal utile déjà précédemment déterminé et pris en compte.

13. Procédé selon une des revendications précédentes, **caractérisé en ce qu'**on détermine et on prend en compte pour une nouvelle détermination de la largeur, de bande passante (55') à des intervalles de temps réguliers des signaux voisins à l'intérieur d'une plage de fréquence partielle (53) limitée quant à la bande de fréquence radio concernée, aux alentours de la fréquence de réception du signal utile, en particulier des signaux voisins dans une plage de fréquence partielle (53) de ± 300 kHz.

14. Procédé selon une des revendications précédentes, **caractérisé en ce que**, pour le réglage de la largeur de bande passante (55, 55') sélectionnée pour le filtrage en fréquence intermédiaire, on active un filtre parmi plusieurs filtres différents (23, 24, 25) présentant chacun une caractéristique de filtrage prédéterminée, ou on modifie quasi en continu les caractéristiques de filtrage d'un filtre numérique (47).

15. Procédé selon une des revendications précédentes, **caractérisé en ce qu'**on prend en compte pour la sélection de la largeur de bande passante (55, 55') du filtrage en fréquence intermédiaire une valeur limite maximale et/ou minimale prédéterminée de la largeur de bande passante.

16. Dispositif de réception radio comportant
- un récepteur radio (11) pour la réception d'un signal utile sur une fréquence de réception,
- une unité de filtrage en fréquence intermédiaire (17, 47) pour le filtrage d'un signal en fréquence intermédiaire correspondant au signal utile et
- une unité de sélection du filtrage pour la sélection de la largeur de bande passante (55, 55') pour l'unité de filtrage en fréquence intermédiaire (17, 47) du récepteur audio (11),
pour la mise en oeuvre du procédé selon une des revendications précédentes,
**caractérisé en ce qu'**est prévu un récepteur additionnel (13) essentiellement indépendant du récepteur audio (11) pour la réception d'un signal voisin sur une fréquence voisine proche de la fréquence de réception du récepteur (11),
**en ce qu**'un paramètre de signal du signal voisin du récepteur additionnel (13) et un paramètre de signal du signal utile du récepteur radio (11) peuvent être déterminés par l'unité de sélection du filtrage,
**en ce que** l'unité de sélection du filtrage présente un dispositif de traitement des signaux (45) pour compenser les uns par rapport aux autres au moins le paramètre de signal du signal utile, le paramètre de signal du signal voisin, et l'écart de fréquence (54) entre la fréquence de réception et la fréquence voisine,
et en ce la largeur de bande passante (55, 55') de l'unité de filtrage en fréquence intermédiaire (17, 47) du récepteur radio (11) peut être sélectionnée en fonction d'un signal de sortie du dispositif de traitement des signaux (45).

17. Dispositif de réception radio selon la revendication 16, **caractérisé en ce que** l'unité de sélection du filtrage comprend un dispositif de détermination des fréquences pour la détermination de l'écart de fréquence (54) entre la fréquence de réception et la fréquence voisine.

18. Dispositif de réception radio selon la revendication 16 ou la revendication 17, **caractérisé en ce que** le dispositif de traitement des signaux (45) est conçu sous la forme d'un microprocesseur.

19. Dispositif de réception radio selon une des revendications 16 à 18, **caractérisé en ce que** l'unité de sélection du filtrage présente un détecteur de niveau (30) associé au récepteur audio (11), un détecteur de niveau (40) associé au récepteur additionnel (13) et/ou un détecteur de la qualité de réception (29) associé au récepteur audio (11).

20. Dispositif de réception radio selon une des revendications 16 à 19, **caractérisé en ce que** le récepteur additionnel (33) est conçu sous la forme d'un récepteur de données qui convient pour la réception de données radio codées numériquement, en particulier de signaux RDS.

21. Dispositif de réception radio selon une des revendications 16 à 20, **caractérisé en ce que** l'unité de filtrage en fréquence intermédiaire (17, 47) du récepteur audio (11) présente au moins deux, de préférence trois, filtres pouvant être actionnés séparément (23, 24, 25) présentant une largeur de bande passante (55, 55') prédéterminée différente, ou un filtre numérique (47) dont la largeur de bande passante (55, 55') peut être modifiée à l'intérieur de limites prédéterminées sur une pluralité d'échelons.

## Claims

1. Method for the control of the passband width (55, 55') in the filtering of an intermediate frequency signal of an audio receiver (11) of a radio reception apparatus,
wherein a signal parameter of a wanted signal of the audio receiver (11) which is received on a reception frequency is determined and taken into account,
**characterized in that**
a signal parameter of at least one adjacent signal is determined which is received at an adjacent frequency adjacent to the reception frequency (61, 69); and
**in that** the passband width (55, 55') of the intermediate frequency filtering is selected (63, 71) in dependence on at least the signal parameter determined from the wanted signal, on the signal parameter determined from the adjacent signal and on the frequency separation (54) between the reception frequency and the adjacent frequency.

2. Method in accordance with claim 1 **characterized in that** the signal strength of the wanted signal, the deviation of the wanted signal and/or an output signal of a reception quality detector (29, 39) associated with the wanted signal, in particular an ultrasonic noise (USN) signal, is taken into account as the signal parameter of the wanted signal.

3. Method in accordance with any one of the preceding claims, **characterized in that** the signal strength of the adjacent signal and/or the deviation of the adjacent signal is taken into account as the signal parameter of the adjacent signal.

4. Method in accordance with any one of the preceding claims, **characterized in that**, prior to the taking into account of the respective signal parameter of the wanted signal or of the adjacent signal for the selection of the passband width (55, 55'), these signals are each heterodyned to intermediate frequency signals and are amplified as intermediate frequency signals.

5. Method in accordance with any one of the preceding claims, **characterized in that**, for the selection of the passband width (55, 55') of the intermediate frequency filtering, the relevant signal parameter of the wanted signal and the relevant signal parameter of the adjacent signal are compared relative to one another.

6. Method in accordance with any one of the preceding claims, **characterized in that** the passband width (55, 55') of the intermediate frequency filtering is selected all the narrower, the higher the signal strength or the deviation of the adjacent signal is with respect to the corresponding signal parameter of the wanted signal and/or the lower the frequency separation (54) between the reception frequency and the adjacent frequency is.

7. Method in accordance with any one of the preceding claims, **characterized in that** the adjacent signal is determined by means of an additional receiver (13) which is substantially independent of the audio receiver (11).

8. Method in accordance with claim 7, **characterized in that** the additional receiver (13) is designed as a data receiver for the reception of digitally coded radio data, in particular RDS signals.

9. Method in accordance with any one of the preceding claims, **characterized in that** the passband width (55, 55') of the intermediate frequency filtering is additionally selected in dependence on the bit error rate of an RDS signal received on the reception frequency.

10. Method in accordance with any one of the preceding claims, **characterized in that**, for a plurality of different adjacent frequencies, the respective adjacent signal and a corresponding signal parameter are determined, the plurality of adjacent frequencies preferably having constant frequency separations from one another.

11. Method in accordance with any one of the preceding claims, **characterized in that** after each determination of a new adjacent signal, a corresponding passband width (55') of the intermediate frequency filtering is determined (63) using the relevant signal parameter of this newly determined adjacent signal and using the frequency separation (54) between the reception frequency and the adjacent frequency of the newly determined adjacent signal; and **in that** the selected passband width (55) is correspondingly updated where appropriate (67).

12. Method in accordance with claim 11, **characterized in that** for the new determination of the passband width (55') the signal parameter of the wanted signal which had already been previously determined and taken into account is determined anew and taken into account.

13. Method in accordance with any one of the preceding claims, **characterized in that** adjacent signals within a part frequency range (53) which is limited with respect to the relevant radio frequency band are determined in the vicinity of the reception frequency of the wanted signal at regular time intervals and are taken into account for a new determination of the passband width (55'), in particular adjacent signals within a part frequency range (53) of ± 300 kHz.

14. Method in accordance with any one of the preceding claims, **characterized in that**, for the setting of the selected passband width (55, 55') of the intermediate frequency filtering, a filter consisting of a plurality of different filters (23, 24, 25) with respective predetermined filter properties is activated or the filter properties of a digital filter (47) are at least approximately continuously varied.

15. Method in accordance with any one of the preceding claims, **characterized in that**, in the selection of the passband width (55, 55') of the intermediate frequency filtering, a predetermined maximum and/or minimum limit value of the passband width is taken into account.

16. Radio reception apparatus comprising
- an audio receiver (11) for the reception of a wanted signal on a reception frequency;
- an intermediate frequency filter unit (17, 47) for the filtering of an intermediate frequency signal corresponding to the wanted signal; and
- a filter selection unit for the selection of a passband width (55, 55') for the intermediate frequency filter unit (17, 47) of the audio receiver (11),
for carrying out the method in accordance with any one of the preceding claims,
**characterized in that**
an additional receiver (13) substantially independent of the audio receiver (11) is provided for the reception of a adjacent signal at a adjacent frequency which is adjacent to the reception frequency of the audio receiver (11);
**in that** a signal parameter of the adjacent signal of the additional receiver (13) and a signal parameter of the wanted signal of the audio receiver (11) can be determined by the filter selection unit;
**in that** the filter selection unit has a signal processing device (45) for the computation of at least the signal parameter of the wanted signal, the signal parameter of the adjacent signal and the frequency distance (54) between the reception frequency and the adjacent frequency with one another; and
**in that** the passband width (55, 55') of the intermediate frequency filter unit (17, 47) of the audio receiver (11) can be selected in dependence on an output signal of the signal processing device (45).

17. Radio reception apparatus in accordance with claim 16, **characterized in that** the filter selection unit has a frequency determination device for the determination of the frequency separation (54) between the reception frequency and the adjacent frequency.

18. Radio reception apparatus in accordance with claim 16 or claim 17, **characterized in that** the signal processing device (45) is formed by a microprocessor.

19. Radio reception apparatus in accordance with any one of the claims 16 to 18 **characterized in that** the filter selection unit has a level detector (30) associated with the audio receiver (11), a level detector (40) associated with the additional receiver (13) and/or a reception quality detector (29) associated with the audio receiver (11).

20. Radio reception apparatus in accordance with any one of the claims 16 to 19, **characterized in that** the additional receiver (13) is designed as a data receiver which is adapted for the reception of digitally coded radio data, in particular RDS signals.

21. Radio reception apparatus in accordance with any one of the claims 16 to 20, **characterized in that** the intermediate frequency filter unit (17, 47) of the audio receiver (11) has at least two, preferably three, individually activatable filters (23, 24, 25) of different predetermined passband width (55, 55') or a digital filter (47), the passband width (55, 55') of which can be varied in a large number of steps within predetermined limits.
